Europäisches Patentamt

European Patent Office

Office européen des brevets

(11) Veröffentlichungsnummer: **0 199 051**

**A1**

(12) **EUROPÄISCHE PATENTANMELDUNG**

(21) Anmeldenummer: **86103247.2**

(22) Anmeldetag: **11.03.86**

(51) Int. Cl.4: **G01R 21/00** , **G06F 15/20**

(30) Priorität: **28.03.85 DE 3511279**

(43) Veröffentlichungstag der Anmeldung:
**29.10.86 Patentblatt 86/44**

(84) Benannte Vertragsstaaten:
**DE FR GB IT NL**

(71) Anmelder: **Leisenberg, Wolfgang, Dr.-Ing.**
**Richard-Wagner-Strasse 2a**
**D-6312 Laubach 1(DE)**

(72) Erfinder: **Leisenberg, Wolfgang, Dr.-Ing.**
**Richard-Wagner-Strasse 2a**
**D-6312 Laubach 1(DE)**

(74) Vertreter: **Engelhardt, Guido, Dipl.-Ing.**
**Montafonstrasse 35 Postfach 1350**
**D-7990 Friedrichshafen 1(DE)**

(54) **Einrichtung zur Erfassung und Auswertung impulsförmig anfallender Messdaten.**

(57) Bei einer Einrichtung (1) zur Erfassung und Auswertung impulsförmig anfallender Meßdaten sind an ein zentrales Auswertungsgerät (2) vorzugsweise über ein Auslesegerät (4) die Meßdaten mehrerer aufnehmender und speichernder Erfassungsgeräte - (3, 3' ...) in größeren Zeitabständen wahlweise übermittelbar.

Dadurch ist es möglich, über einen längeren Zeitraum die kurzfristig anfallenden Impulse eines Impulskontaktes (15) festzuhalten, diese in einer beliebigen Zeit einzulesen und auch in beliebiger Form auszuwerten.

EP 0 199 051 A1

1

2

7

4

5

6

17

11

13

3/3'

12

14

16

15

## Einrichtung zur Erfassung und Auswertung impulsförmig anfallender Meßdaten

In verschiedenen Bereichen der Durchflußmessung von Stoff-und Energieströmen werden Meßgeräte verwendet, welche quantisierte Durchflußgrößen in Form von Impulsen ausgeben. Oftmals besteht hierbei die Notwendigkeit, zur Analyse, Überwachung und Optimierung von Energie- und Stoffströmen den Verlauf der Ströme über die Zeit zu erfassen.

Bei größeren Anlagen werden hierfür die Informationen über Drahtverbindungen an eine Zentrale übermittelt und dort ausgewertet. In anderen Anlagen werden druckende Zähler mit einfachen Vorauswertungen eingesetzt.

In vielen Fällen ist jedoch eine Stromversorgung nicht vorhanden, so daß eine Fernübertragung nicht möglich ist. Hier ist es häufig zwar nicht erforderlich, momentan über die entsprechenden Informationen zu verfügen, doch ist es auch hier nützlich, den Meßwertverlauf in regelmäßigen Abständen nachträglich auszuwerten. Bisher sind dazu nur Zähler verfügbar, welche in bestimmten Abständen abgelesen werden müssen.

Druckende Geräte haben einen relativ großen Energieverbrauch, sind also für netzunabhängigen Betrieb nur bedingt einsetzbar und darüber hinaus relativ aufwendig, so daß ein Einsatz an kleineren Stationen in größerer Stückzahl nicht nützlich ist. Der Bauaufwand derartiger Anlagen ist demnach, da die Meßwerte einer Meßstelle jeweils in einem dieser zugeordneten Auswertungsgerät verarbeitet werden, beträchtlich.

Aufgabe der Erfindung ist es daher, eine Einrichtung zur Erfassung und Auswertung impulsförmig anfallender Meßdaten zu schaffen, mittels der es bei geringem Bau-und Energieaufwand möglich ist, über einen längeren Zeitraum die kurzzeitig eintreffenden Impulse eines Impulskontaktes festzuhalten, diese zu einer beliebigen Zeit auszulesen und auch in beliebiger Form auszuwerten.

Gemäß der Erfindung wird dies dadurch erreicht, daß an ein zentrales Auswertungsgerät vorzugsweise über ein Auslesegerät die Meßdaten mehrerer aufnehmender und speichernder Erfassungsgeräte in größeren Zeitabständen wahlweise übertragbar sind.

Die Erfassungsgeräte einer in dieser Weise aufgebauten Einrichtung sollten jeweils einen Prozessorbaustein, einen Uhrenbaustein, einen Speicher sowie eine Impulsformerstufe als Funktionsgruppen enthalten, mittels der die dem Erfassungsgerät zugeleiteten Impulse für je einen Erfassungszeitraum in je einer gesonderten Speicherzelle des Speichers ablegbar und insgesamt mittels des Auslesegerätes, vorzugsweise mitdem Zeitpunkt des Auslesens versehen, abrufbar und durch dieses oder dem Auswertungsgrät in das gültige Kalenderzeitraster einfügbar sind.

Zweckmäßig ist es hierbei, wegen des geringen Stromverbrauchs, die Funktionsbaugruppen in CMOS-Technik aufzubauen und den Prozessorbaustein des Erfassungsgerätes als einen 4-Bit-Einchip-Rechner auszubilden, der im Stand-by Modus betreibbar ist.

Des weiteren sollte der Speicher wegen der Datensicherheit derart ausgelegt sein, daß für einzelne Speicherbereiche Prüfsummen bildbar sind.

Angebracht ist es auch, das Erfassungsgerät zur Kontrolle mit einem Gesamtsummenspeicher zu versehen.

Außerdem kann die Einrichtung mit einem setzbaren Zähler und/oder einem nicht setzbaren Zähler versehen werden. Der setzbare Gesamtsummenzähler kann auf den Stand eines meist parallel zum Impulsspeicher vorhandenen mechanischen Zählwerkes gesetzt werden, so daß eine leichte Überprüfung der Funktionsfähigkeit gegeben ist.

Da aufgrund der erfindungsgemäßen Einrichtung nur eine geringe Zahl von Auslese-und Auswertegeräten im Vergleich zu der Zahl der Erfassungsgeräte vorhanden ist, ist es des weiteren zweckmäßig, die Funktion des Gerätes ohne Benutzung eines Erfassungs-oder Auswertegerätes überprüfbar zu machen. Dazu kann das Erfassungsgerät mit einer Anzeigeeinheit zur Überprüfung der Gerätefunktion z. B. in Form einer Flüssigkeits-Kristallanzeige zur Feststellung der Uhrzeit und/oder des Datums und/oder der Zählerstände ausgestattet werden. Zweckmäßigerweise wird hierbei der Prozessor derart ausgelegt sein, daß sich die Anzeige eine bestimmte Zeit nach dem Test selbst abschaltet; der Stromverbrauch des Gerätes wird dadurch möglichst gering gehalten.

Ferner kann dem Auslesegerät zum Speichern der ausgelesenen Daten ein nicht flüchtiger Speicher mit auswechselbarem Datenträger z. B. in Form eines Magnetbandes oder einer Diskette zugeordnet werden.

Das Auslesegerät sollte derart ausgelegt sein, daß es im Speicher des Erfassungsgerätes für den Zeitpunkt der Auslesung eine Marke setzen kann.

Bei der erfindungsgemäßen Ausgestaltung einer Einrichtung zur Erfassung und Auswertung impulsförmig anfallender Meßdaten ist berücksichtigt, daß die Auswertung für eine größere Anzahl von Meßstellen nur einmal vorhanden sein muß, die Auslesung ebenfalls nur in wenigen Exemplaren für einen bestimmten Bereich benötigt wird, die Erfassungsgeräte dagegen in relativ großer Stückzahl eingesetzt werden sollen. Es wurde somit eine Einrichtung geschaffen, die in der Erfassung äußerst einfach in ihrem Aufbau und in ihrer Ausgestaltung ist und die vor allem zur Auswertung der Meßdaten einer Vielzahl von Meßstellen nur ein Auswertungsgerät erfordert, wobei die diesem zugeordneten Erfassungsgeräte zum Betrieb nur eine äußerst geringe Energiemenge benötigen. Und dies wird mit den insbesondere in den Ansprüchen 1 und 2 angegebenen Kennzeichnungen erreicht.

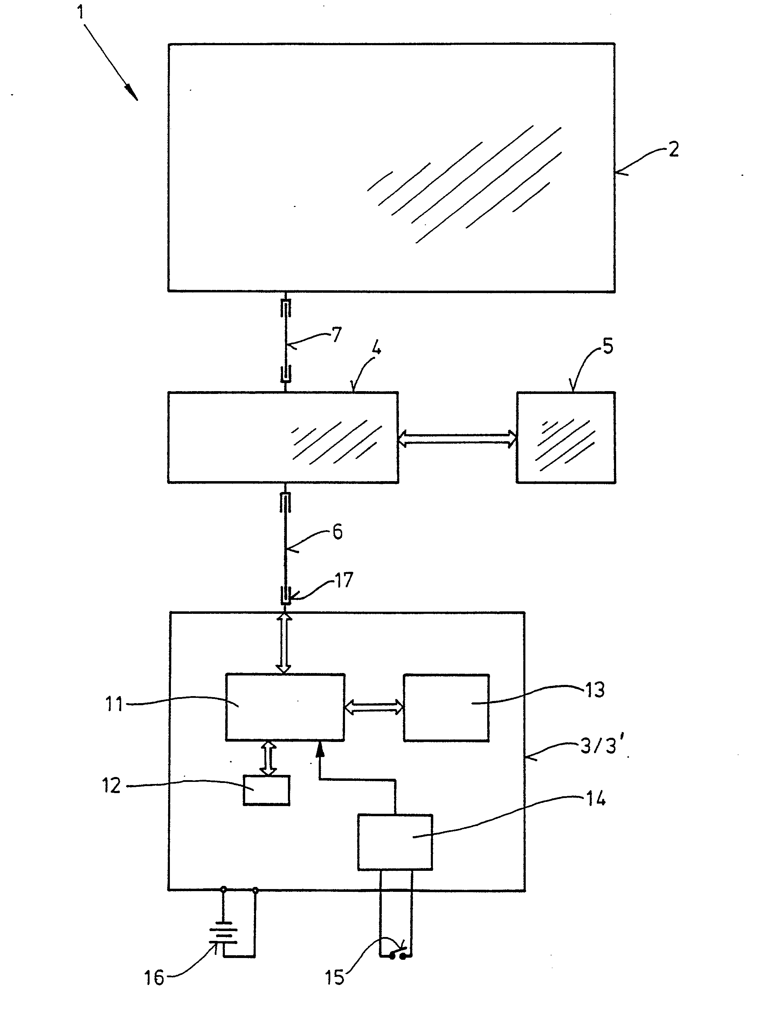

In der Zeichnung ist ein Ausführungsbeispiel der gemäß der Erfindung ausgebildeten Einrichtung zur Erfassung und Auwertung impulsförmig anfallender Meßdaten dargestellt, das nachfolgend im einzelnen erläutert ist.

Die mit 1 bezeichnete Einrichtung zur Erfassung und Auswertung impulsförmig anfallender Meßdaten besteht im wesentlichen aus einem Auswertungsgerät 2, einem Erfassungsgerät 3 zur Aufnahme der anfallenden Meßdaten und einem Auslesegerät 4, die mittels Leitungen 6 und 7 wahlweise miteinander verbindbar sind. Die von dem Erfassungsgerät 3 augenommenen Meßdaten können somit in vorgegebenen Zeitabständen von diesem abgerufen, in das Auslesegerät 4 übertragen und in dem Auswertungsgerät 2 entsprechend ausgewertet werden.

Das Erfassungsgerät 3 weist hierbei einen Prozessorbaustein 11, einen Uhrenbaustein 12, einen Speicher 13 sowie eine Impulsformerstufe 14 auf. Um den Stromverbrauch möglichst gering zu halten und auch Schwankungen der Versorgungsspannung in Kauf nehmen zu können, ist die gesamte Schaltung in CMOS-Technik aufgebaut.

Extern werden ein Impulskontakt 15, eine Batterie 16 sowie über einen Stecker 17 das Auslesegerät 4 an das Erfassungsgerät 3 angeschlossen.

Geht man von der Forderung aus, daß mit Impulse eines Jahres mit einer Auflösung von 12 Bit erfaßt werden müssen, so wird für den Speicherbereich eine Größe von 16 k x 8 benötigt. Als Prozessorbaustein 11 sind maskenprogrammierbare 4-Bit-Einchip-Rechner erhältlich, welche alle erforderlichen Funktionen in einem Chip enthalten und zudem, ebenso wie die Speicher im Stand-by Betrieb arbeiten und dabei außerordentlich geringe Leistung aufnehmen.

Ein derartig aufgebautes Gerät stellt vom Hardware-Aufbau eine minimale Konfiguration dar, benötigt in der Größenordnung von 30 mAh/Jahr elektrische Energie und ist aufgrund der CMOS-Technologie im Bereich von -40...+85 Grad C arbeitsfähig. Es erfüllt damit alle genannten Forderungen von der Hardware her, und zwar auch bei ungünstigen Umweltbedingungen.

Die Software der Einrichtung 1 beschränkt sich auf die Funktionen:

Impulserfassung und Aufsummierung je Stunde oder sonstigen Zeitintervall,

Bilden von Prüfsummen und Gesamtsumme,

Detektieren des Zeitintervallwechsels,

Ausgabe der gespeicherten Daten,

Synchronisieren der Uhr und

Auslesen und Setzen einer Gerätenummer.

Der normale Funktionsablauf besteht somit nur darin, bei Eintreffen eines Impulses aus dem Stand-by Modus aktiv zu werden, diesen Impuls zu der entsprechend dem Zeitintervall aktiven Speicherzelle zu addieren und bei Intervallwechsel auf die nächstfolgende Speicherzelle umzuschalten.

Um eine Überprüfung des Speicherinhaltes zu ermöglichen, wird über einen bestimmten Zeitraum die Gesamtsumme der Impulse gebildet und in einer zugeordneten Prüfzelle abgelegt. Dies ermöglicht nach Auslesen des Speicherinhaltes eine Überprüfung auf dessen Richtigkeit sowie eine Lokalisierung des evtl. defekten Speicherbereiches.

Zweckmäßigerweise wird die jeweils älteste Speicherzelle überschrieben, so · daß bei dem genannten Speicherbereich von 16 k x 8 Bit bei Stundenintervallen jeweils die letzten 14 Monate im Speicher abgelegt sind.

Bei der Auslesung der Daten durch das Auslesegerät 4 wird zunächst über das Lesen der Uhr geprüft, ob diese innerhalb der zulässigen Toleranzen gearbeitet hat. Im Anschluß daran wird sie mit der im Auslesegerät 4 befindlichen Zeit synchronisiert.

Daraufhin werden alle Speicherregister der Reihe nach ausgelesen und mit den entsprechenden Prüfsummen der Bereiche verglichen. Schließlich werden ein Gesamtzähler sowie die Nummer des jeweils angeschlossenen Erfassungsgerätes 3, 3' ausgelesen und im Auswertungsgerät 2 festgehalten.

Das Auslesungsgerät 4 übernimmt die Daten zunächst in seinen Arbeitsspeicher und überträgt sie dann auf einen an dieses angeschlossenen nicht flüchtigen portablen Speicher 5, der als Band oder Floppydisk ausgebildet sein kann.

Zu den Informationen des Erfassungsgerätes 3 fügt das Auslesegerät 4 das genaue Datum und die Uhrzeit der Auslesung sowie ein Zeichen hinzu, daß der Speicherinhalt mit den Prüfsummen übereinstimmt bzw. nicht übereinstimmt.

Bei Bedarf kann noch der Zählerstand eines parallel milaufenden mechanischen Zählwerkes eingegeben und im Erfassungsgerät 3 eine Marke für den Zeitpunkt der Auslesung gesetzt werden. Letzteres ermöglicht durch den Zählerfortschritt zwischen den Auslesungen einen Vergleich zwischen dem internen Gesamtsummenzähler und dem externen mechanischen Zählwerk; dies ist für die Absicherung im tariflichen Bereich erforderlich.

Die auf dem nicht flüchtigen Speicher 5 abgelegten Informationen können durch das Auslesegerät 4 selbst oder durch Weitergabe des Speichermediums an das zentrale Auswertungsgerät 2 analysiert werden.

Durch die Reduktion der Information auf die Folge von Stunden oder auch andere Zeiteinheiten mit den zugehörigen Zählerinhalten läßt sich in Verbindung mit dem ebenfalls festgehaltenen Auslesezeitpunkt eine eindeutige kalendarische Zuordnung der Meßwerte erreichen, wobei die gesamte Information über den Kalender, wie Zeitsprünge bei Sommer-und Winterzeit und Sprünge im Tarifgefüge im Rechner des Auswertungsgerätes 2 abgelegt sind. Dieses ist beispielsweise als Tischcomputer ausgeführt und kann neben diesen Zuordnungen nun alle Auswertungs-Software von der Feststellung von Tages-, Wochen-, Monats-und Jahresmaxima bis hin zu grafischen und statistischen Auswertungen jede beliebige Zuordnung bewerkstelligen, obwohl das eigentliche Erfassungsgerät 3 nichts weiter als eine Sequenz von Zählerständen für bestimmte Zeitabstände aufgenommen hat.

Dabei ist es möglich, das Auslesegerät 4 und das Auswertungsgerät 2 bei Bedarf in einem Gerät zusammenzufassen und so eine -zumindest grobe -Auswertung vor Ort möglich zu machen.

**Ansprüche**

1. Einrichtung zur Erfassung und Auswertung impulsförmig anfallender Meßdaten,

**dadurch gekennzeichnet,**

daß an ein zentrales Auswertungsgerät (2) vorzugsweise über ein Auslesegerät (4) die Meßdaten mehrerer aufnehmender und speichernder Erfassungsgeräte (3, 3'...) in größeren Zeitabständen wahlweise übermittelbar sind.

2. Einrichtung nach Anspruch 1,

**dadurch gekennzeichnet,**

daß das Erfassungsgerät (3) einen Prozessorbaustein (11), einen Uhrenbaustein (12), einen Speicher (13) sowie eine Impulsformerstufe (14) als Funktionsgruppen enthält, mittels denen die dem Erfassungsgerät (3) zugeleiteten Impulse für je einen Erfassungszeitraum in je einer gesonderten Speicherzelle des Speichers (13) ablegbar und der gesamte Speicherinhalt mittels des Auslesegerätes (4) vorzugsweise mit dem Zeitpunkt des Auslesens abrufbar und durch dieses oder dem Auswertungsgerät (2) in das gültige Kalenderzeitraster einfügbar sind.

3. Einrichtung nach Anspruch 1 oder 2,

**dadurch gekennzeichnet,**

daß die Funktionsbaugruppen (11, 12, 13, 14) in CMOS-Technik aufgebaut sind.

4. Einrichtung nach einem oder mehreren der Ansprüche 1 bis 3,

**dadurch gekennzeichnet,**

daß der Prozessorbaustein (11) des Erfassungsgerätes (3) als ein 4 Bit-Einchip-Rechner ausgebildet ist, der im Stand-by Modus betreibbar ist.

5. Einrichtung nach einem oder mehreren der Ansprüche 1 bis 4,

**dadurch gekennzeichnet,**

daß der Speicher (13) des Erfassungsgerätes (3) derart ausgelegt ist, daß für einzelne Speicherbereiche Prüfsummen bildbar sind.

6. Einrichtung nach einem oder mehreren der Ansprüche 1 bis 5,

**dadurch gekennzeichnet,**

daß das Erfassungsgerät (3) mit einem Gesamtsummenspeicher versehen ist.

7. Einrichtung nach einem oder mehreren der Ansprüche 1 bis 6,

**dadurch gekennzeichnet,**

daß die Einrichtung (1) mit einem setzbaren Zähler und/oder einem nicht setzbaren Gesamtsummenzähler versehen ist.

8. Einrichtung nach einem oder mehreren der Ansprüche 1 bis 7,

**dadurch gekennzeichnet,**

daß das Erfassungsgerät (3) mit einer vorzugsweise selbst abschaltbaren Anzeigeeinheit zur Überprüfung der Gerätefunktion z. B. in Form einer Flüssigkeitskristallanzeige zur Feststellung der Uhrzeit und/oder des Datums und/oder der Zählerstände versehen ist.

9. Einrichtung nach einem oder mehreren der Ansprüche 1 bis 8,

**dadurch gekennzeichnet,**

daß dem Auslesegerät (4) zum Speichern der ausgelesenen Daten ein nicht flüchtiger Speicher (5) mit auswechselbarem Datenträger z. B. in Form eines Magnetbandes oder einer Diskette (12) zugeordnet ist.

10. Einrichtung nach einem oder mehreren der Ansprüche 1 bis 9,

**dadurch gekennzeichnet,**

daß das Auslesegerät (4) derart ausgelegt ist, daß durch dieses in dem Speicher (13) des Erfassungsgerätes (3) für den Zeitpunkt der Auslesung eine Marke setzbar ist.

A 5366

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | LANDIS & GYR MITTEILUNGEN, Band 24, Nr. 3, Seiten 2-8; H. SEEGER: "Programmierbare Apparate DATAGYR FAB ... zur modernen Zählwert-Verarbeitung" * Seite 2, rechte Spalte, Absatz "2. Systembeschreibung" - Seite 3, rechte Spalte "3. Mechanischer Aufbau"; Figur 1 * | 1-2,6-9 | G 01 R 21/00 G 06 F 15/20 |
| X | BULLETIN ASE/UCS, Band 72, Nr. 9, 1981; Seiten 460-463; P. WULLSCHLEGER: "Energie- und Leistungsmessung mit elektronischen Verfahren" * Seite 462, Figur 5; Seite 463; Figuren 6-8 * | 1-2 | |
| X | REGELUNGSTECHNISCHE PRAXIS, Band 20, Nr. 6, 1978, Seiten 177-183; A. SOCEANU: "Überwachung und Steuerung des elektrischen Energieverbrauchs mittels Prozessrechner" * Seite 177, linke Spalte "1. Problemstellung"; Figur 1 * | 1 | RECHERCHIERTE SACHGEBIETE (Int. Cl.4) G 01 R 21/00 G 06 F 15/20 |
| A | DE-A-3 044 000 (S.P. KENNEDY) * Ansprüche 1-5, 25; Figur 1 * | 1,10 | |

Der vorliegende Recherchenbericht wurde für alle Patentansprüche erstellt.

| Recherchenort | Abschlußdatum der Recherche | Prüfer |
|---|---|---|
| BERLIN | 11-06-1986 | LEMMERICH J |